# EUROPEAN PATENT SPECIFICATION

(11) **EP 3 363 564 B1**
(45) Date of publication and mention of the grant of the patent: **23.09.2020**
(21) Application number: 17157176.3
(22) Date of filing: 21.02.2017
(51) Int. Cl.: B22F 3/105, H01J 37/30, H01J 37/317, B33Y 30/00

(54) **ELECTRICALLY DISCHARGING PARTICLES BY INCREASING INTER-PARTICLE CONDUCTIVITY**
ELEKTRISCHES ENTLADEN VON PARTIKELN AUFGRUND EINER STEIGERUNG DER INTERPARTIKELLEIFHÄFIGKEIT
DÉCHARGE ELECTRIQUE DANS DES GRANULES DUE À L'AUGMENTATION DE LA CONDUCTIVITÉ INTERGRANULAIRE

(43) Date of publication of application: 22.08.2018
(73) Proprietor: Technische Universität München, 80333 München (DE)
(72) Inventor: Janson, Stephan, 86152 Augsburg (DE)
(74) Representative: Lucke, Andreas

(56) References cited:
- EP-A1- 2 937 163
- WO-A1-2016/044561
- US-A- 6 136 257
- US-A1- 2016 279 873
- US-A1- 2016 368 056

## Description

### TECHNICAL FIELD

The present invention relates to removing unwanted electrical charge from particles. In particular, the present invention relates to reducing or preventing an accumulation of electrostatic charge on particles, for example, during a process involving electron beam heating of the particles.

### BACKGROUND

When inter-particle conductivity is substantially inhibited due to, for example, only small areas of contact between particles or electrical insulation caused by particles having an insulating surface layer such as, for example, a native oxide layer, electrostatic charge may accumulate on the particles.

The resulting electrostatic force may lead to unwanted effects such as adhesion of particles on surfaces or particle dispersion. Moreover, the electrostatic charge accumulation may lead to sparking.

Techniques for eliminating static electricity of a powder material by means of two electron guns whose electron beams are tilted with respect to one another are disclosed in EP 2 937 163 A1.

US 2016/0279873 A1 discloses techniques for enhancing uniformity of a powder deposition by means of electrostatic charges between the powder sprayed from a spray head and the building platform. US 2016/0368056 A1 likewise discloses the compaction of the applied powder layer to increase the density of the powder bed through the use of electrostatic fields and, if necessary, the generation of a plasma.

US 6,136,257 describes a process for producing a powder layer with a very thin powder nozzle (compared to the particle size), which would tend to clog due to the adhesion of particles. By ionizing and thus making the surrounding atmosphere conductive, the charging of the particles can be prevented and their flowability in the thin nozzle gap ensured.

### SUMMARY

The present invention relates to a method according to independent claims 1 and 7, and a system according to independent claim 8. The dependent claims relate to preferred embodiments.

The first method comprises applying an electromagnetic force to charge carriers of an accumulation of particles, the particles comprising an electrically conductive material, the electromagnetic force applied to the charge carriers to improve or provide for an electrical connection between the particles, and selectively heating the particles to form an object comprising solidified material of fully or partially melted particles by exposing a region of the accumulation to an electron beam, wherein particles of the accumulation charged by the electron beam are discharged via the electrical connection between the particles.

The electromagnetic force applied to the charge carriers causes disruptive discharge through contact areas or insulating surface layers, thereby improving or providing for an electrical connection between the particles by fusing (e.g., micro-welding). This allows reducing an accumulation of electrostatic charge on the particles during heating, as the resistance inhibiting discharge is decreased. In this regard, it is noted that the term "charge carriers" as used throughout the description and claims in particular refers to freely movable electrons in the particles. Hence, the formulation "charge carriers of an accumulation of particles" is to be interpreted as encompassing the scope of the formulation "charge carriers in an accumulation of particles", as it is not intended to limit the meaning of said formulation to exclusively refer to an accumulation of particles that is divided into charged particles and "not-charged" particles (although this could be the case). Rather, said formulation is intended to be understood as referring to particles comprising charge carriers which are free to move in the electrically conductive material and thus, within the particles.

Preferably, the method further comprises grounding the particles.

For example, some of the particles may be in contact with an electrode and the disruptive discharge of charge carriers may provide for an electrical connection between the electrode and the particles abutting on the electrode surface by fusing, thereby decreasing resistance inhibiting discharge to ground.

Preferably, the electrically conductive material is metal.

Hence, high electrical conductivity between particles may be achieved which allows for high discharge current during heating.

Preferably, the particles have a native oxide surface layer.

A native oxide layer having a thickness in the range of, for example, less than 10 nm allows for limiting the required electromagnetic force and hence, the heat generated during disruptive discharge. Thus, melting of particles can be substantially avoided, even for particles of small size.

Preferably, the solidified material of fully or partially melted particles forms a material layer of the object.

Hence, a process involving additive manufacturing by selectively heating the particles may be improved, as particle dispersion during heating may be decreased by reducing the accumulation of electrostatic charge on the particles.

Preferably, the applied electromagnetic force is induced by an electromagnetic wave or a voltage applied to two or more electrodes adjacent or connected to the accumulation.

By using an electromagnetic wave, the process can be made robust against small dislocation of the accumulation. Moreover, by applying a voltage to two or more electrodes adjacent or connected to the accumulation, the current through the electrodes can be measured and be used to determine the conductivity and/or to control the voltage to be applied.

Preferably, the electromagnetic force is a force pulse.

Hence, the time interval during which the electromagnetic force is applied can be kept short and thus the heat generated in particles during disruptive discharge can be further limited.

The second method comprises applying an electromagnetic force to charge carriers of an accumulation of charged particles, the charged particles comprising an electrically conductive material and an electrically insulating surface layer, the electromagnetic force applied being configured to fuse the particles to the charge carriers to provide for an electrical connection through the insulating surface layer and discharging the particles of the accumulation via the provided electrical connection through the insulating surface layer.

As indicated above, disruptive discharge of charge carriers through the insulating surface layer provides for an electrical connection between the particles and/or an electrode on which the particles abut and hence reduces an accumulation of electrostatic charge on the particles

The system comprises a processing chamber and an electron beam device, wherein the electron beam device is configured to selectively heat a powder layer in the processing chamber to form a material layer of an object, wherein the system further comprises a device for applying an electromagnetic force to the powder layer, wherein the applied electromagnetic force is induced by an electromagnetic wave or voltage applied to 2 or more electrodes adjacent or connected to the powder layer, the electromagnetic force being configured to fuse particles of the powder layer, to increase electrical conductivity of the powder layer.

In this regard, it noted that the term "powder" as used throughout the description and claims, particularly refers to a multitude or an accumulation of particles such as, for example, a powder bed. Moreover, electrical conductivity between the particles is increased by inducing heat to the contact areas of the particles to fuse the particles.

Preferably, the processing chamber is configured to connect the powder layer during heating to ground.

Hence, charge carriers accumulating on the particles during heating may be discharged to ground to avoid displacement of the powder particles. Thus, it may be avoided that displaced particles obstruct or widen the electron beam.

Preferably, the device for applying an electromagnetic force to the powder layer is configured to apply a voltage pulse to the powder layer.

Hence, the time interval during which the voltage is applied to the powder layer can be kept short and thus heat generated in the particles during disruptive discharge can be further limited.

the device comprises a plurality of electrode pairs, the electrodes of each electrode pair adjacent or connected to the powder layer at different regions of the powder layer, the device being further configured to successively apply voltage pulses to the electrode pairs.

Hence, a particle may be fused with particles abutting on different sides of the particle, thereby forming a mesh of electrical paths through the powder layer which provides for higher overall conductivity of the powder layer.

Preferably, the device for applying an electromagnetic force to the powder layer is configured to induce the electromagnetic force by generating an electromagnetic wave.

By using an electromagnetic wave, the process can be made robust against a small dislocation of the accumulation.

Preferably, the device for applying the electromagnetic force to the powder layer is configured to generate electromagnetic waves by spark discharge.

Hence, a short powerful pulse may be generated, which allows for disruptive discharge of charge carriers through an insulation surface layer such as, for example, a native oxide layer.

Preferably, the system further comprises a powder feeder, wherein the powder feeder is configured to successively deposit further powder layers on the object.

Hence, an object can be manufactured layer-by-layer, thereby enabling the manufacturing of complex 3D geometries.

### BRIEF DESCRIPTION OF THE DRAWINGS

The foregoing aspects and many of the attendant advantages of this document will become more readily appreciated as the same becomes better understood by reference to the following detailed description, when taken in conjunction with the accompanying drawings, wherein like reference numerals refer to like parts throughout the various views, unless otherwise specified.
Fig. 1 and Fig. 2 are schematic views of a system according to a preferred embodiment taken at different steps of a process of increasing inter-particle conductivity;
Fig. 3 illustrates a modification to the system of Fig. 1 and 2;
Fig. 4 illustrates a modification to the system of Fig. 3;
Fig. 5 illustrates another modification to the system of Fig. 1 and 2;
Fig. 6 illustrates yet another modification to the system of Fig. 1 and 2;
Fig. 7 shows a flowchart of a process of increasing inter-particle conductivity; and
Fig. 8 shows a flowchart of another process of increasing inter-particle conductivity.

### DETAILED DESCRIPTION

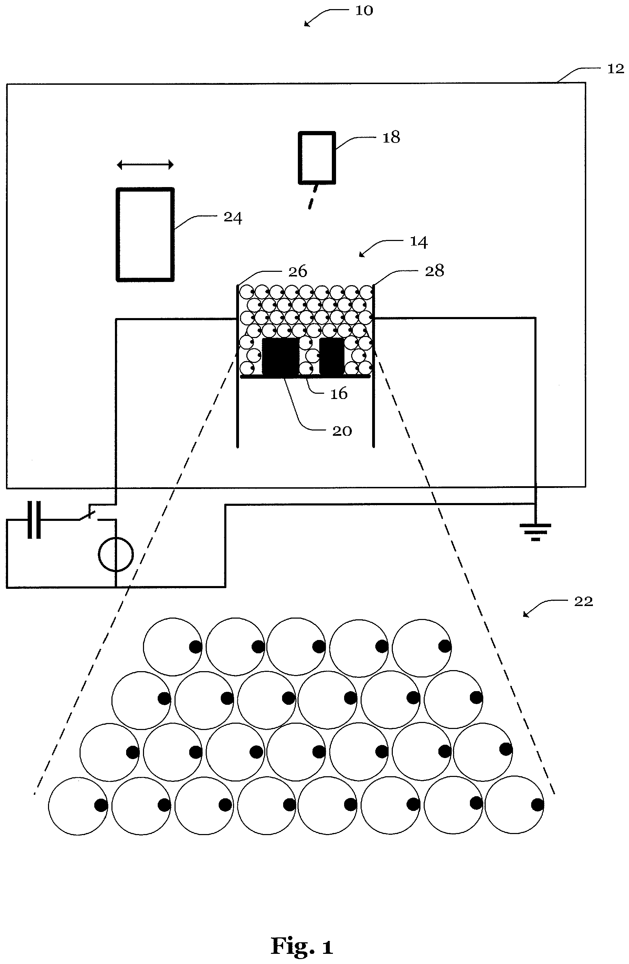

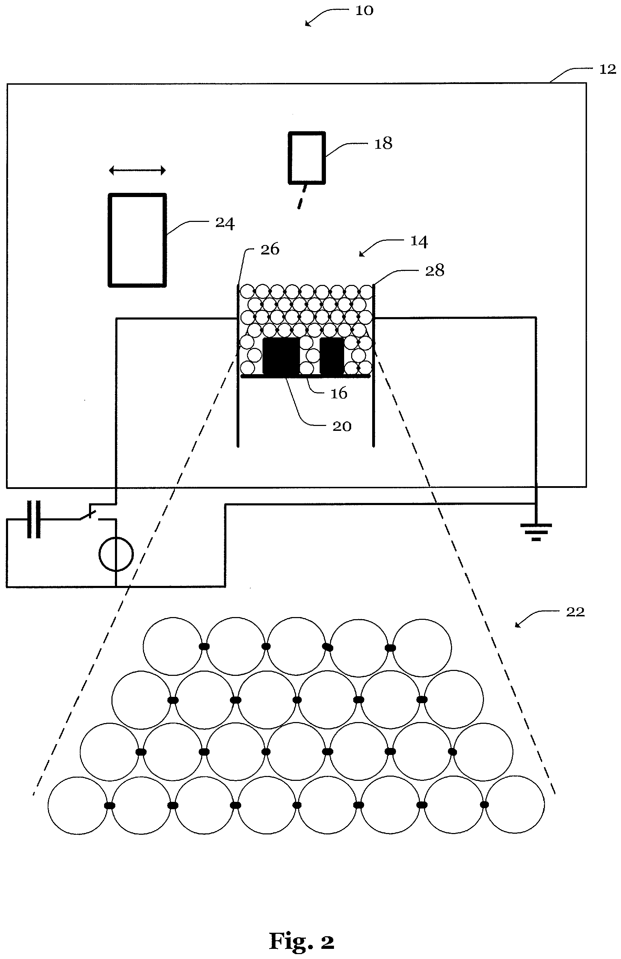

Fig. 1 and Fig. 2 are schematic views of a system 10 for additive manufacturing. The system 10 comprises a processing chamber 12 with a powder bed 14 on a platform 16. The system 10 further comprises an electron beam device 18 arranged within or upon the processing chamber 12. The electron beam device 18 is configured to emit an electron beam onto the powder bed 14. The electron beam device 18 may be movable within a horizontal plane and/or the electron beam may be deflectable by electromagnetic coils within the electron beam device 18 to allow for the powder bed 14 to be selectively heated. Moreover, the electron beam device 18 may be vertically movable. Furthermore, one or more focusing coils may be provided to focus the electron beam. The processing chamber 12 may be evacuated or contain a low-pressure (e.g., helium) atmosphere to avoid widening or obstruction of the electron beam.

Due to heat induced by the electron beam, powder particles may be fused with each other to form an object 20. After fusing the particles, the platform 16 may be lowered to increase the thickness of the particle bed and a further particle (powder) layer 22 (of substantially constant thickness) may be provided by a powder feeder 24. For example, the power feeder 24 may traverse the platform 16 in horizontal direction and deposit the particle layer 22 onto the object 20. In addition, a blade or roller may be used to provide for a substantially plain surface of the particle layer 22. The particle layer 22 may then be selectively heated (by the electron beam) to add a further material layer to the object 20. By repeating this process, a plurality of (solid) material layers may be added to the object 20 layer-by-layer.

Before heating a deposited particle layer 22, the system 10 may carry out a process for improving inter-particle conductivity. For example, the system 10 may measure conductivity of the particle layer 22 and initiate the process, if the conductivity of the particle layer 22 is below a threshold. Alternatively, the process may be initiated for each deposited particle layer 22, irrespective of particle layer 22 conductivity. Particularly, the process involves applying an electromagnetic force to charge carriers of the particles to fuse contact areas of the particles.

For instance, Fig. 1 shows a step of the process in which a charged capacitor has been connected (via a switch) to a first electrode 26 abutting on the particle layer 22 (i.e., forming a first wall bordering the powder bed 14). The capacitor may have been charged by a high voltage source, e.g., a circuit comprising a high voltage transformer or a cascade of transformers, to apply a high voltage pulse between the first electrode 26 and a second (grounded) electrode 28 abutting on the particle layer 22 on a side opposite to the first electrode 26 (i.e., forming a second wall bordering the powder bed 14). However, depending on the amount of energy required, the capacitor may not be needed and the first electrode 26 and the second electrode 28 may be connected to a (switch mode) high voltage power supply instead.

As shown in Fig. 1, electrons flowing from the charged capacitor to the first electrode 26 generate an electric field between the first electrode 26 and the second electrode 28. The electric field induces an electromagnetic force on charge carriers of the particles of the particle layer 22. In the example of Fig. 1, the force is directed towards the second electrode 28 although the direction could be reversed without imparting from the inventive concept. If the contact areas of the particles exhibit high resistance, the contact areas will be fused (e.g., welded) due to heat induced by the current through the contact areas, as schematically illustrated in Fig. 2.

The fused contact areas improve inter-particle conductivity by providing material links of low electrical resistance between the particles. For example, if the particles contain metal, the fused contact areas may contain links of solidified melted metal. In addition, if the particles are covered by insulating surface layers, such as native oxide surface layers, the link will extend therethrough. Moreover, conductivity between particles and the first electrode 26 and the second electrode 28 may also be improved by fused contact areas of particles abutting on the first electrode 26 and the second electrode 28, respectively.

For example, the first electrode 26 and the second electrode 28 and the particles may be made from the same material to facilitate fusing the contact areas. Moreover, a current between the first electrode 26 and the second electrode 28 may be monitored by a control circuit (not shown) of the system 10 and cut-off, if a threshold is met, to avoid generating too strong links that might pose problems when removing the object 20 from the powder bed 14 at the end of the additive manufacturing process. Rather, the fused contact areas are desired to break (instantly) when applying vibrations to the powder bed 14. Hence, the system 10 may be equipped with a vibrator (not shown) which is configured to cause the particle bed 14 to vibrate.

Due to the increased inter-particle conductivity, charge carriers such as electrons emitted by the electron beam device 18 may be effectively discharged from the particles. Moreover, if the particle layer 22 is connected to ground as shown in Fig. 1 and 2 (or another suitable reference potential) an accumulation of electrostatic charge in the particle layer 22 may be reduced. By this, powder dispersion may be reduced or inhibited and in consequence, widening and obstruction of the electron beam due to powder dispersion may also be reduced or inhibited.

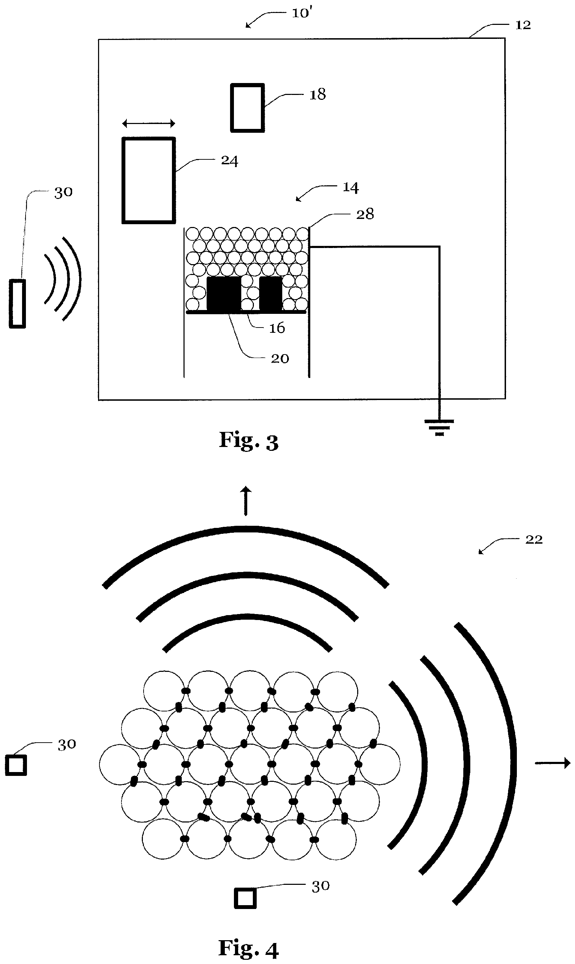

Furthermore, as shown in Fig. 3, inducing an electromagnetic force on charge carriers of the particles of the particle layer 22 may also be achieved by generating an electromagnetic wave travelling through the particle layer 22. For example, a modified system 10' may comprise an electromagnetic wave generator 30 such as a spark or ignition coil connected to the capacitor or the (high) voltage source to generate electromagnetic waves. As shown in Fig. 3, the electromagnetic wave may travel through a non-conductive first wall on one side of the powder bed 14. Moreover, the electromagnetic waves may be directed at a grounded electrode 28 forming a second wall on another side of the powder bed 14. In addition, it is to be noted that although the electromagnetic wave generator 30 is depicted outside the processing chamber 12, the electromagnetic wave generator 30 may also be arranged within the processing chamber 12 to avoid obstruction or blocking of the electromagnetic wave by a wall of the processing chamber 12. For example, the wall of the processing chamber 12 may be made from metal such as, for example, stainless steel or lead, thus forming a Faraday cage.

In addition, as schematically illustrated in Fig. 4, electromagnetic waves (e.g., generated by two or more electromagnetic wave generators 30 or a steerable/movable electromagnetic wave generator 30) may travel through the particle layer 22 along different (e.g., perpendicular) directions (as indicated by the arrows in Fig. 4) to provide for a two-dimensional or three-dimensional mesh of fused particles. For example, a first electromagnetic wave may be caused to travel through the particle layer 22 along a first direction and a second electromagnetic wave may be caused to travel through the particle layer 22 along a second direction which is different from the first direction.

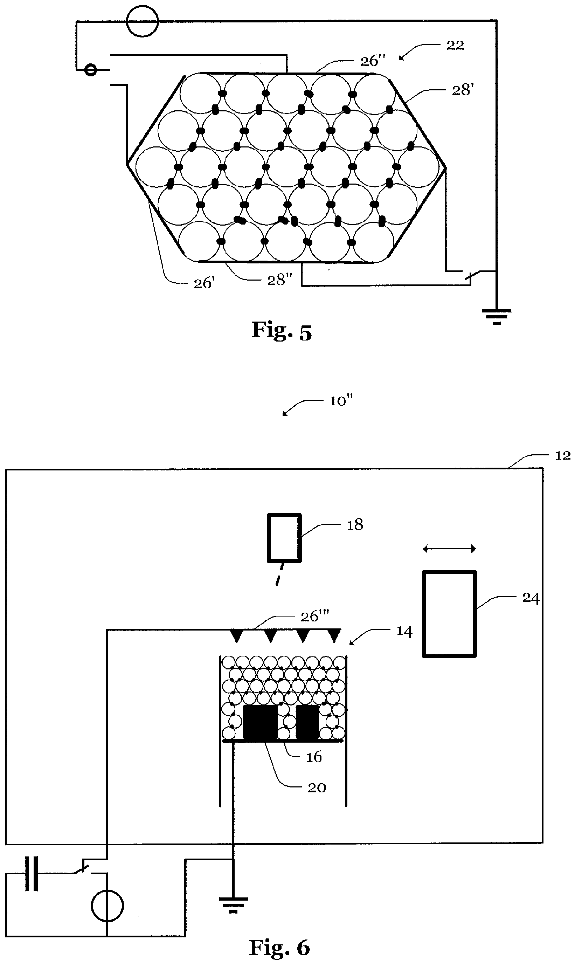

As shown in Fig. 5, a similar modification may be applied to the system 10 of Fig. 1 and 2 by providing for multiple electrode pairs, e.g., a first electrode pair 26' and 28' and a second electrode pair 26" and 28" to which voltage pulses are applied consecutively. For example, a ring of electrode segments may be arranged around the powder bed 14 and voltage pulses may be consecutively applied to opposite electrode segments.

A yet further modification of the system 10 of Fig. 1 and 2 or of the modification shown in Fig. 5 is shown in Fig. 6. Instead of abutting on the particle layer 22 and forming a first wall bordering the powder bed 14, an electrode 26'" may be provided which is placed adjacent to the particle layer 22, i.e., above the particle layer 22 with a gap between the particle layer 22 and the electrode 26"'. Moreover, the platform 16 may be grounded to provide for vertically connected particle strings. As shown in Fig. 6, the electrode 26'" may have dimensions similar to the particle layer 22 and may comprise one or more sharp tips pointing at the particle layer 22. Moreover, instead of a single electrode 26'" (e.g., with a sharp tip) pointing at the particle layer 22, there may be provided a plurality of such electrodes distributed over the area above the particle layer 22 which may be sequentially energized.

As such, the systems 10 and 10" of Fig. 1, 2, 5, and 6 may comprise any combination of the shown electrode pairs 26, 26', 26", 28, 28" and 16, respectively, which may be energized (and grounded) sequentially to provide for strings of connected particles extending along different directions (e.g., horizontally and/or vertically). Furthermore, analogous modifications may also be made to the system 10' of Fig. 3 and 4, e.g., by grounding the platform and directing the electromagnetic wave to travel through the particle layer 22 from top to bottom.

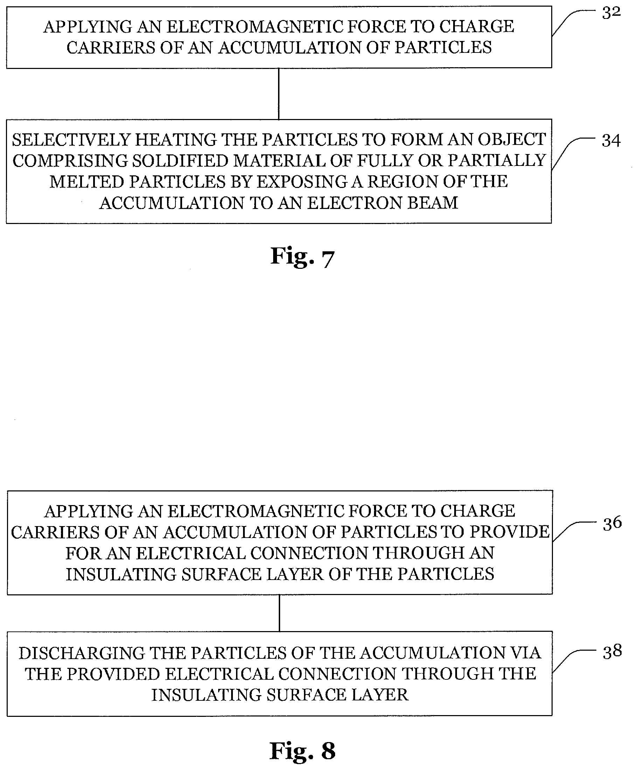

Fig. 7 shows a flowchart of the process. As indicted at step 32, the process begins by applying an electromagnetic force to charge carriers of an accumulation of particles such as the particle layer 22. As indicated above, the electromagnetic force may be caused by an electromagnetic field which may, for example, be generated by applying a voltage to electrodes on two sides of (e.g., sandwiching) the accumulation, by generating an electromagnetic wave travelling through the accumulation, etc. The generated electromagnetic field should be strong enough to allow for disruptive discharge of the charge carriers through the contact areas but avoid substantial melting of the particles.

Hence, the power for generating the electric field may be cut off immediately after disruptive discharge between the particles has occurred and the contact areas of the particles are fused. For example, conductivity of the accumulation may be monitored and used to control the power/voltage used to generate the electric field. When the conductivity of the accumulation of particles has reached a desired value, or is within a desired region, the process may continue at step 34 with selectively heating the particles to form the object 20 comprising solidified material of fully or partially melted particles by exposing a region of the accumulation to the electron beam.

Moreover, it is to be noted that the described process is also applicable to particles that are to be freed of electrostatic charge accumulating on an isolating surface layer. For example, as indicated at step 36 of the flowchart of Fig. 8, the process may start with applying an electromagnetic force to charge carriers of an accumulation of particles to provide for an electrical connection through an insulating surface layer of the particles. Hence, by applying the electromagnetic force to charge carriers, disruptive discharge through the insulating surface layer may be caused and, as indicated at step 38, the particles of the accumulation may be discharged via the provided material linlc/electrical connection through the insulating surface layer.

Hence, the treatment of an accumulation of particles by applying an electromagnetic force may allow freeing the particles from electrostatic charge on an insulating surface layer as well as increasing inter-particle conductivity by fusing contact areas of the particles to avoid an accumulation of electrostatic charge. In this regard, it is to be noted that the described steps for improving inter-particle conductivity may also be used for other purposes as preparing a powder layer 22 for electron beam melting.

For example, the described steps may also be applied in battery manufacturing to increase conductivity of particle based anodes and cathodes. Moreover, the steps may also be used in the pretreatment of metallic powders which are to be used or stored in areas which are subject to explosion hazards. Furthermore, the steps may also be used for the adjustment of the conductivity of material powder such as, for example, powder comprising conductive plastics. Even further, conductivity of material powder may be increased by fusing contact areas of the particles and decreased by breaking the links. For instance, this would allow for switching between different conductivity values. Moreover, material powder may be provided with different conductivity in different directions and/or in different regions.

### LIST OF REFERENCE SIGNS

- 10, 10', 10": system
- 12: processing chamber
- 14: particle bed
- 16: platform
- 18: electron beam device
- 20: object
- 22: particle layer
- 24: powder feeder
- 26, 26', 26", 26'": electrode
- 28, 28', 28": electrode
- 30: electromagnetic wave generator
- 32-38: steps

## Claims

1. A method, comprising:
applying (32) an electromagnetic force to charge carriers of an accumulation of particles (22), the particles comprising an electrically conductive material , wherein the applied electromagnetic force is induced by an electromagnetic wave or a voltage applied to two or more electrodes (26, 26', 26", 28, 28', 28") adjacent or connected to the accumulation (22), the electromagnetic force applied to the charge carriers being configured to fuse the particles to improve or provide for an electrical connection between the particles; and
selectively heating (34) the particles to form an object (20) comprising solidified material of fully or partially melted particles by exposing a region of the accumulation (22) to an electron beam, wherein particles of the accumulation (22) charged by the electron beam are discharged via the electrical connection between the particles.

2. The method of claim 1, further comprising grounding the particles.

3. The method of claim 1 or 2, wherein the electrically conductive material is metal.

4. The method of claim 3, wherein the particles have a native oxide surface layer.

5. The method of any one of claims 1 to 4, wherein the solidified material of fully or partially melted particles forms a material layer of the object (12).

6. The method of any one of the preceding claims, wherein the electromagnetic force is a force pulse.

7. A method for preparing a powder layer for electron beam melting comprising:
applying (36) an electromagnetic force to charge carriers of an accumulation of charged particles, the charged particles comprising an electrically conductive material and an electrically insulating surface layer, wherein the applied electromagnetic force is induced by an electromagnetic wave or a voltage applied to two or more electrodes (26, 26', 26", 28, 28', 28") adjacent or connected to the accumulation (22), the electromagnetic force applied to the charge carriers being configured to fuse the particles to provide for an electrical connection through the insulating surface layer; and
discharging (38) the particles of the accumulation via the provided electrical connection through the insulating surface layer.

8. A system (10, 10', 10"), comprising:
a processing chamber (12); and
an electron beam device (18); wherein
the electron beam device (18) is configured to selectively heat a powder layer (22) in the processing chamber (12) to form a material layer of an object (20);
**characterized in that**
the system (10, 10') further comprises a device for applying an electromagnetic force to the powder layer (22), wherein the applied electromagnetic force is induced by an electromagnetic wave or a voltage applied to two or more electrodes (26, 26', 26", 28, 28', 28") adjacent or connected to the powder layer, the electromagnetic force being configured to fuse particles of the powder layer to increase electrical conductivity of the powder layer (22).

9. The system (10, 10', 10") of claim 8, wherein the processing chamber (12) is configured to connect the powder layer (22) during heating to ground.

10. The system (10, 10', 10") of claim 8 or 9, wherein the device for applying an electromagnetic force to the powder layer is configured to apply a voltage pulse to the powder layer (22).

11. The system (10, 10', 10") of claim 10, wherein the device comprises a plurality of electrode pairs (26', 26", 26"', 28', 28"), the electrodes of each electrode pair (26', 26", 26"', 28', 28") adjacent or connected to the powder layer (22) at different regions of the powder layer (22), the device being further configured to successively apply voltage pulses to the electrode pairs (26', 26", 26"', 28', 28").

12. The system (10, 10', 10") of any of the claims 8 to 11, wherein the device for applying the electromagnetic force to the powder layer (22) is configured to generate electromagnetic waves by spark discharge.

13. The system (10, 10', 10") of any one of claims 8 to 12, further comprising a powder feeder (24), wherein the powder feeder (24) is configured to successively deposit further powder layers (22) on the object (20).

## Patentansprüche

1. Verfahren, umfassend:
Ausüben (32) einer elektromagnetischen Kraft auf Ladungsträger in einer Ansammlung von Partikeln (22), wobei die Partikel ein elektrisch leitfähiges Material umfassen und die ausgeübte elektromagnetische Kraft durch eine elektromagnetische Welle oder durch eine Spannung, die an zwei oder mehr Elektroden (26, 26', 26", 28, 28', 28") angelegt ist, die benachbart zu oder in Kontakt mit der Ansammlung (22) angebracht sind, erzeugt wird, wobei die auf die Ladungsträger ausgeübte elektromagnetische Kraft dazu eingerichtet ist, um die Partikel zu verschmelzen, um eine elektrisch leitfähige Verbindung zwischen den Partikeln zu verbessern oder herzustellen;
selektives Erhitzen (34) der Partikel zum Ausbilden eines Objekts (20), das festes Material aus vollständig oder teilweise aufgeschmolzenen Partikeln enthält, durch Bestrahlen eines Bereichs der Ansammlung (22) mit einem Elektronenstrahl, wobei sich Partikel der Ansammlung (22), die durch den Elektronenstrahl aufgeladen wurden, entladen, indem die Ladung durch die elektrisch leitfähige Verbindung zwischen den Partikeln abfließt.

2. Verfahren nach Anspruch 1, bei dem die Partikel elektrisch geerdet werden.

3. Verfahren nach Anspruch 1 oder 2, bei dem das leitfähige Material aus Metall oder Metallen besteht.

4. Verfahren nach Anspruch 3, bei dem die Partikel eine native Oxidoberflächenschicht aufweisen.

5. Verfahren nach einem der Ansprüche 1 bis 4, bei dem das feste Material aus vollständig oder teilweise aufgeschmolzenen Partikeln eine Materialschicht des Objekts (20) bildet.

6. Verfahren nach einem der Ansprüche 1 bis 5, bei dem die elektromagnetische Kraft ein Kraftpuls ist.

7. Verfahren, umfassend:
Ausüben (36) einer elektromagnetischen Kraft auf Ladungsträger in einer Ansammlung von geladenen Partikeln, wobei die geladenen Partikel ein elektrisch leitfähiges Material und eine elektrisch isolierende Oberflächenschicht umfassen und die ausgeübte elektromagnetische Kraft durch eine elektromagnetische Welle oder durch eine Spannung, die an zwei oder mehr Elektroden (26, 26', 26", 28, 28', 28") angelegt ist, die benachbart zu oder in Kontakt mit der Ansammlung (22) angebracht sind, erzeugt wird, wobei die auf die Ladungsträger ausgeübte elektromagnetische Kraft dazu eingerichtet ist, um die Partikel zu verschmelzen, um eine elektrisch leitfähige Verbindung durch die elektrisch isolierende Oberflächenschicht zu erzeugen; und
Entladen (38) der Partikel der Ansammlung mittels der erzeugten elektrisch leitfähigen Verbindung durch die elektrisch isolierende Oberflächenschicht.

8. System (10, 10', 10") mit:
einer Prozesskammer (12); und
einer Elektronenstrahlvorrichtung (18); wobei
die Elektronenstrahlvorrichtung (18) dazu eingerichtet ist, selektiv eine Pulverschicht (22) in der Prozesskammer (12) zu erhitzen, um eine Materialschicht eines Objekts (20) zu bilden;
**dadurch gekennzeichnet, dass**
das System (10, 10') zudem eine Vorrichtung zum Ausüben einer elektromagnetischen Kraft auf die Pulverschicht (22) umfasst, wobei die ausgeübte elektromagnetische Kraft erzeugt wird durch eine elektromagnetische Welle oder durch eine Spannung, die an zwei oder mehr Elektroden (26, 26', 26", 28, 28', 28"), die benachbart zu oder in Kontakt mit der Pulverschicht (22) sind, angelegt wird, wobei die elektromagnetische Kraft dazu eingerichtet ist, um Partikel in der Pulverschicht zu verschmelzen, um eine elektrische Leitfähigkeit der Pulverschicht (22) zu erhöhen.

9. System (10, 10', 10") nach Anspruch 8, bei dem die Prozesskammer (12) dazu eingerichtet ist, die Pulverschicht (22) während des Erhitzens elektrisch zu erden.

10. System (10, 10', 10") nach Anspruch 8 oder 9, bei dem die Vorrichtung zum Ausüben der elektromagnetischen Kraft auf die Pulverschicht dazu eingerichtet ist, einen Spannungspuls an die Pulverschicht (22) anzulegen.

11. System (10, 10', 10") nach Anspruch 10, bei dem die Vorrichtung mehrere Elektrodenpaare (26', 26", 26"', 28', 28") umfasst und die Elektroden eines jeden Elektrodenpaares (26', 26", 26"', 28', 28") an unterschiedlichen Bereichen der Pulverschicht benachbart zu oder in Kontakt mit der Pulverschicht (22) sind, wobei die Vorrichtung ferner dazu eingerichtet ist, aufeinander folgende Spannungspulse an die Elektrodenpaare (26', 26", 26''', 28', 28") anzulegen.

12. System (10, 10', 10") nach einem der Ansprüche 8 bis 11, bei dem die Vorrichtung zum Ausüben der elektromagnetischen Kraft an die Pulverschicht (22) dazu eingerichtet ist, elektromagnetische Wellen durch Bogenentladung zu erzeugen.

13. System (10, 10', 10") nach einem der Ansprüche 8 bis 12, das eine Pulverzuführung (24) umfasst, die dazu eingerichtet ist, sukzessive weitere Pulverschichten (22) auf das Objekt (20) aufzubringen.

## Revendications

1. Procédé, comprenant :
l'application (32) d'une force électromagnétique à des porteurs de charge d'une accumulation de particules (22), les particules comprenant un matériau électro-conducteur, dans lequel la force électromagnétique appliquée est induite par une onde électromagnétique ou une tension appliquée à deux électrodes ou plus (26, 26', 26", 28, 28', 28") adjacentes ou connectées à l'accumulation (22), la force électromagnétique appliquée aux porteurs de charge étant configurée pour fusionner les particules pour améliorer ou fournir une connexion électrique entre les particules ; et
le chauffage sélectif (34) des particules pour former un objet (20) comprenant un matériau solidifié de particules pleinement ou partiellement fondues en exposant une région de l'accumulation (22) à un faisceau d'électrons, dans lequel les particules de l'accumulation (22) chargée par le faisceau d'électrons sont déchargées via la connexion électrique entre les particules.

2. Procédé selon la revendication 1, comprenant en outre la mise à la terre des particules.

3. Procédé selon la revendication 1 ou 2, dans lequel le matériau électro-conducteur est du métal.

4. Procédé selon la revendication 3, dans lequel les particules ont une couche de surface d'oxyde native.

5. Procédé selon l'une quelconque des revendications 1 à 4, dans lequel le matériau solidifié de particules pleinement ou partiellement fondues forme une couche de matériau de l'objet (12).

6. Procédé selon l'une quelconque des revendications précédentes, dans lequel la force électromagnétique est une impulsion de force.

7. Procédé destiné à préparer une couche de poudre par fusion de faisceau d'électrons comprenant :
l'application (36) d'une force électromagnétique à des porteurs de charge d'une accumulation de particules chargées, les particules chargées comprenant un matériau électro-conducteur et une couche de surface électro-isolante, dans lequel la force électromagnétique appliquée est induite par une onde électromagnétique ou une tension appliquée à deux électrodes ou plus (26, 26', 26", 28, 28', 28") adjacentes ou connectées à l'accumulation (22), la force électromagnétique appliquée aux porteurs de charge étant configurée pour fusionner les particules pour fournir une connexion électrique par le biais de la couche de surface isolante ; et
la décharge (38) des particules de l'accumulation via la connexion électrique fournie par le biais de la couche de surface isolante.

8. Système (10, 10', 10"), comprenant :
une chambre de traitement (12) ; et
un dispositif à faisceau d'électrons (18) ; dans lequel
le dispositif à faisceau d'électrons (18) est configuré pour chauffer de manière sélective une couche de poudre (22) dans la chambre de traitement (12) pour former une couche de matériau d'un objet (20) ;
**caractérisé en ce que**
le système (10, 10') comprend en outre un dispositif destiné à appliquer une force électromagnétique à la couche de poudre (22), dans lequel la force électromagnétique appliquée est induite par une onde électromagnétique ou une tension appliquée à deux électrodes ou plus (26, 26', 26", 28, 28', 28") adjacentes ou connectées à la couche de poudre, la force électromagnétique étant configurée pour fusionner des particules de la couche de poudre pour augmenter la conductivité électrique de la couche de poudre (22).

9. Système (10, 10', 10") selon la revendication 8, dans lequel la chambre de traitement (12) est configurée pour connecter la couche de poudre (22) pendant le chauffage à la terre.

10. Système (10, 10', 10") selon la revendication 8 ou 9, dans lequel le dispositif destiné à appliquer une force électromagnétique à la couche de poudre est configuré pour appliquer une impulsion de tension à la couche de poudre (22).

11. Système (10, 10', 10") selon la revendication 10, dans lequel le dispositif comprend une pluralité de paires d'électrodes (26', 26", 26"', 28', 28"), les électrodes de chaque paire d'électrodes (26', 26", 26"', 28', 28") étant adjacentes ou connectées à la couche de poudre (22) au niveau de différentes régions de la couche de poudre (22), le dispositif étant en outre configuré pour appliquer de manière successive des impulsions de tension aux paires d'électrodes (26', 26", 26"', 28', 28").

12. Système (10, 10', 10") selon l'une quelconque des revendications 8 à 11, dans lequel le dispositif destiné à appliquer la force électromagnétique à la couche de poudre (22) est configuré pour générer des ondes électromagnétiques par décharge par étincelles.

13. Système (10, 10', 10") selon l'une quelconque des revendications 8 à 12, comprenant en outre un élément d'alimentation en poudre (24), dans lequel l'élément d'alimentation en poudre (24) est configuré pour déposer de manière successive d'autres couches de poudre (22) sur l'objet (20).
